# EUROPÄISCHE PATENTSCHRIFT

(11) **EP 1 088 239 B1**
(45) Veröffentlichungstag und Bekanntmachung des Hinweises auf die Patenterteilung: **31.05.2006**
(21) Anmeldenummer: 99938179.1
(22) Anmeldetag: 11.06.1999
(51) Int. Cl.: G01R 31/317

(54) **EINRICHTUNG ZUR VERMESSUNG UND ANALYSE VON ELEKTRISCHEN SIGNALEN EINES INTEGRIERTEN SCHALTUNGSBAUSTEINS**
DEVICE FOR MEASURING AND ANALYZING ELECTRICAL SIGNALS OF AN INTEGRATED CIRCUIT COMPONENT
DISPOSITIF POUR MESURER ET ANALYSER DES SIGNAUX ELECTRIQUES D'UN CIRCUIT INTEGRE

(30) Priorität: 16.06.1998 DE 19826825
(43) Veröffentlichungstag der Anmeldung: 04.04.2001
(60) Teilanmeldung: 03016279.6
(73) Patentinhaber: Infineon Technologies AG, 81669 München (DE)
(72) Erfinder: SCHMID, Wilhelm, D-85055 Ingolstadt (DE); DÖRRHÖFER, Carsten, D-83607 Holzkirchen (DE)
(74) Vertreter: Jannig, Peter
(86) Internationale Anmeldenummer: PCT/DE1999/001719
(87) Internationale Veröffentlichungsnummer: WO 1999/066337

(56) Entgegenhaltungen:
- EP-A- 0 650 069
- US-A- 5 712 858

## Beschreibung

Die Erfindung betrifft eine Einrichtung gemäß dem Oberbegriff des Anspruchs 1.

Um Fehlfunktionen und Taktkonzepte auf integrierten Schaltungsbausteinen analysieren zu können, ist es erforderlich, chipinterne Signale zu beobachten, also Signale, die an nicht zugänglichen Schaltungsstellen innerhalb des integrierten Schaltungsbausteins vorliegen. Dabei spielt sehr häufig eine zeitgenaue Signalbeobachtung eine wichtige Rolle. Dazu müssen beispielsweise Takte gegeneinander vermessen werden, asynchrone Signale wie Interrupts vermessen werden und Funktionen in Abhängigkeit von asynchronen Signalen analysiert werden.

Bei den bisherigen Analysen wurden spezielle, technisch äußerst aufwendige und deswegen auch sehr teure Analysegeräte verwendet. Für eine solche Analyse ist es erforderlich, den integrierten Schaltungsbaustein zu öffnen und für die Messungen zu präparieren. Durch diese Maßnahmen verändert sich aber das elektrische Verhalten der Schaltung und es ist teilweise nicht mehr möglich, Fehler zu reproduzieren.

Nicht zugängliche Schaltungsstellen können auch aufgrund der Definition und des Designs von integrierten Schaltungsbausteinen bedingt sein. Werden beispielsweise integrierte Schaltungen in den neuen, sogenannten BGA(Ball Grid Array)-Gehäusen und dann im System auf einer Systemplatte montiert, so sind am BGA-Gehäuse die Kontaktpunkte (Balls) zum Systemboard nicht mehr zugänglich, da sich die Kontaktpunkte auf der Unterseite des Gehäuses befinden und damit zwischen Gehäuse und Systemboard verschwinden. Somit sind die Signale an den Kontaktpunkten für Analyse- und Testzwecke nicht mehr abgreifbar. Bei Einsatz von TQPF-Gehäusen für integrierte Halbleiterschaltungen beispielsweise stellt sich dieses Problem nicht, da auch im System die Signale direkt an den Pins abgegriffen werden können.

Bei BGA-Gehäusen werden dagegen auf dem Systemboard die wichtigsten Signale auf Testpunkte geführt und von dort weiter zum angeschlossenen Chip. Dies kostet zum einen Platz auf dem jeweiligen Systemboard, was zwangsläufig mit zusätzlichen Kosten verbunden ist, und zum anderen zusätzlichen Aufwand bei der Entflechtung, bei der die entsprechenden Signale erst an die Oberfläche der teilweise mehrlagigen Leiterplatte geführt werden müssen. Aus diesen Gründen werden nur sehr wenige Signale auf Testpunkte geführt, was bedeutet, daß es im Fehlerfall durchaus möglich ist, daß gerade das gewünschte Signal nicht abgreifbar ist.

Aus der EP 0 650 069 A ist eine Einrichtung gemäß dem Oberbegriff des Anspruchs 1 bekannt. Eine solche Einrichtung löst einige, aber nicht alle der vorstehend genannten Probleme.

Der Erfindung liegt die Aufgabe zugrunde, eine technisch wenig aufwendige Möglichkeit zu schaffen, um die an nicht zugänglichen Schaltungsstellen eines integrierten Schaltungsbausteins vorliegenden Signale, z.B. chipinterne Signale oder alle Signale an den Kontaktpunkten einer von einem BGA-Gehäuse eingeschlossenen integrierten Halbleiterschaltung, beobachten zu können, so daß Tests bzw. Analysen auch bei auffällig gewordenen Serienprodukten ohne weiteres durchgeführt werden können.

Diese Aufgabe wird erfindungsgemäß durch die in Anspruch 1 beanspruchte Einrichtung gelöst.

Eine solche Einrichtung ermöglicht es, interne Chipsignale sichtbar zu machen und das zeitliche Verhalten genau zu bestimmen.

Dabei wird für die Bestimmung des zeitlichen Signalverhaltens zusätzlich zum zu analysierenden Signal ein Referenzsignal verfügbar gemacht. Um zeitgenaue Analysen von chipinternen Signalen wie z.B. von Taktsignalen und asynchronen Signalen zu ermöglichen, werden also nach der Erfindung mindestens zwei externe Test-Anschlußkontaktstellen realisiert.

Bei den nicht zugänglichen Signalen kann es sich also um interne Chipsignale des integrierten Schaltungsbausteins handeln, der so ausgelegt ist, daß diese Signale einschließlich von Referenzsignalen selektiv durchschaltbar an die externen Test-Anschlußkontaktstellen geleitet sind.

Die nicht zugänglichen Signale können aber auch Signale umfassen, die an nicht zugänglichen Kontaktpunkten des Gehäuses eines integrierten Schaltungsbausteins vorliegen, wobei diese Signale einschließlich von Referenzsignalen in selektiver Durchschaltung an die Test-Anschlußkontaktstellen geleitet sind, die durch besondere der Kontaktpunkte gebildet sind.

Das Gehäuse des integrierten Schaltungsbausteins kann insbesondere ein sogenanntes BGA-Gehäuse (Ball Grid Array-Gehäuse) sein, bei dem die durch Kontaktpunkte (Balls) realisierten Test-Anschlußkontaktstellen nicht zugänglich sind, weil sich die Kontaktpunkte auf der Unterseite des Gehäuses befinden und damit zwischen dem Gehäuse und einem Systemboard, auf dem das Gehäuse angebracht ist, verschwinden, wobei die besonderen Kontaktpunkte, an welche die zu vermessenden und zu analysierenden Signale anderer Kontaktpunkte sowie die ebenfalls an anderen Kontaktpunkten vorliegenden Referenzsignale in selektiver Durchschaltung zugeleitet sind, mit entsprechend vielen metallischen Testpunkten auf dem Systemboard elektrisch leitend verbunden sind.

Bei Verwendung eines BGA-Gehäuses als Gehäuse des integrierten Schaltungsbausteins werden im BGA-Gehäuse ein oder mehrere Kontaktpunkte definiert, deren Signale auf dem kundenspezifischen Systemboard an Testpunkten sichtbar gemacht werden. Auf diese Kontaktpunkte können die Signale von allen anderen Kontaktpunkten des integrierten Schaltungsbausteins sichtbar gemacht werden.

Im integrierten Schaltungsbaustein ist in vorteilhafter Weise zur selektiven Durchschaltung eine zeitlich gesteuerte Multiplex-Schaltung vorgesehen, über welche die verschiedenen zu vermessenden bzw. zu analysierenden Signale und die jeweiligen Referenzsignale an die Test-Anschlußkontaktstellen durchgeschaltet werden. Ist die zeitlich gesteuerte Multiplex-Schaltung in einem von einem BGA-Gehäuse umschlossenen integrierten Schaltungsbaustein vorgesehen, so sind die nicht als Test-Anschlußkontaktstellen dienenden Kontaktpunkte elektrisch leitend mit Eingängen der Multiplex-Schaltung verbunden, deren Ausgänge mit den besonderen, die Test-Anschlußkontaktstellen bildenden Kontaktpunkten des BGA-Gehäuses elektrisch leitend verbunden sind. Es können dann alle Kontaktpunktsignale beliebig auf die bestimmten Test-Kontaktpunkte gemultiplext werden. Bislang war ein Signal immer eindeutig einem oder sehr wenigen Kontaktpunkten zugeordnet.

Eine vorteilhafte Weiterbildung der Einrichtung nach der Erfindung besteht darin, daß die die selektive Durchschaltung an die Test-Anschlußkontaktstellen vorgebende Steuerung der Multiplex-Schaltung programmierbar ausgebildet ist. Dadurch läßt sich die Multiplex-Schaltung auch während des Betriebes wie benötigt programmieren.

Eine entsprechend der Erfindung ausgebildete Einrichtung kann zur Analyse des integrierten Schaltungsbausteins mittels eines Bausteintesters, dem die an den Test-Anschlußkontaktstellen jeweils vorliegenden Signale zur Analyse eingegeben werden, verwendet werden.

Eine Einrichtung nach der Erfindung läßt sich auch zur direkten Analyse des integrierten Schaltungsbausteins in einer Applikation innerhalb eines Systems einsetzen, wobei die an den Test-Anschlußkontaktstellen vorliegenden Signale vermessen und analysiert werden. Dabei kann zusätzlich auch das System, in welchem der integrierte Schaltungsbaustein eingesetzt ist, analysiert werden.

Die Test-Anschlußkontaktstellen können vorteilhaft wahlweise auch in umgekehrter Betriebsrichtung zur Eingabe von Signalen an die extern unzugänglichen Schaltungsstellen des integrierten Schaltungsbausteins dienen (Eingabe-Mode).

Die Erfindung wird im folgenden anhand von in Zeichnungen dargestellten Ausführungsbeispielen erläutert. Es zeigen:
FIG. 1 die schematische Darstellung eines integrierten elektrischen Halbleiter-Schaltungsbausteins (Chip) mit zwei externen Test-Anschlußkontaktstellen (Pins), über die interne Chip-Signale beobachtet werden können,
FIG. 2 eine ebenfalls schematische Darstellung eines elektrischen Halbleiter-Chips mit zwei externen Test-Pads, über die Signale von im Einbau nicht zugänglichen anderen Pads eines BGA-Gehäuses beobachtet werden können,
FIG. 3 die schematische Ansicht von in einem BGA-Gehäuse montierten elektrischen Halbleiter-Chips in einem Gesamtsystem, und
FIG. 4a, 4b und 4c untereinander eine Ansicht von unten, von der Seite bzw. von oben eines BGA-Gehäuses (Plastic Thin Flat Ball Grid Array).

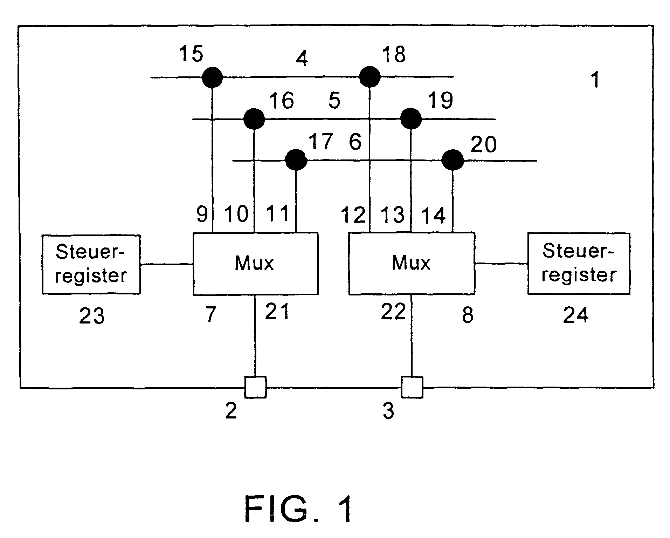

Der in der FIG. 1 schematisch abgebildete integrierte Halbleiter-Schaltungsbaustein (Chip) 1 weist zwei externe Test-Anschlußkontaktstellen (Pins) 2 und 3 auf, über die chipinterne Signale 4, 5 und 6 zeitgenau beobachtet werden können, also Signale, die an nicht ohne weiteres zugänglichen Stellen der Schaltung vorliegen. Es können z.B. Takte gegeneinander vermessen werden, asynchrone Signale wie Interrupts vermessen werden oder Funktionen in Abhängigkeit von asynchronen Signalen analysiert werden. Zwei externe Anschlußkontaktstellen 2 und 3 weist der integrierte Schaltungsbaustein 1 deswegen auf, weil das zeitliche Verhalten genau bestimmt werden soll.

Für eine solche Bestimmung ist zusätzlich zum zu analysierenden Signal an einer der Test-Anschlußkontaktstellen 2 bzw. 3 ein Referenzsignal an der jeweils anderen Test- Anschlußkontaktstelle verfügbar. Daraus folgt, daß zur zeitgenauen Analyse von chipinternen Signalen 4, 5 oder 6 mindestens zwei Test-Anschlußkontaktstellen 2 und 3 vorhanden sein müssen. Zur selektiven Durchschaltung der internen Chipsignale 4, 5 oder 6 sind als Multiplex-Schaltung zwei Multiplexer 7 und 8 vorgesehen, deren Eingänge 9, 10, 11 bzw. 12, 13, 14 mit den signalführenden chipinternen Stellen 15, 16, 17 bzw. 18, 19, 20 verbunden sind. Die Ausgänge 21 und 22 der beiden Multiplexer 7 bzw. 8 sind mit den beiden externen Test-Anschlußkontaktstellen (Pins) 2 bzw. 3 elektrisch verbunden.

Gesteuert wird die Durchschaltung der beiden Multiplexer 7 und 8, die z.B. als Logik oder Tristate realisiert werden können, von jeweils einem Steuerregister 23 bzw. 24, die über einen Controller, einen digitalen Signalprozessor oder einen Tapcontroller während des Betriebs programmierbar sind.

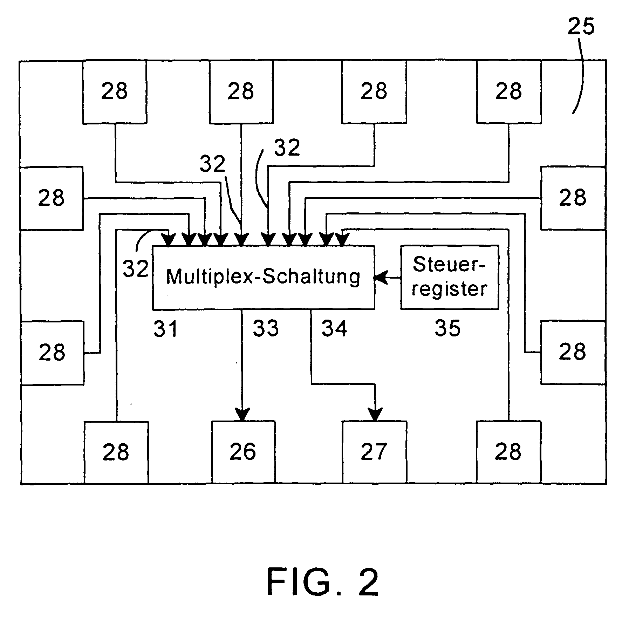

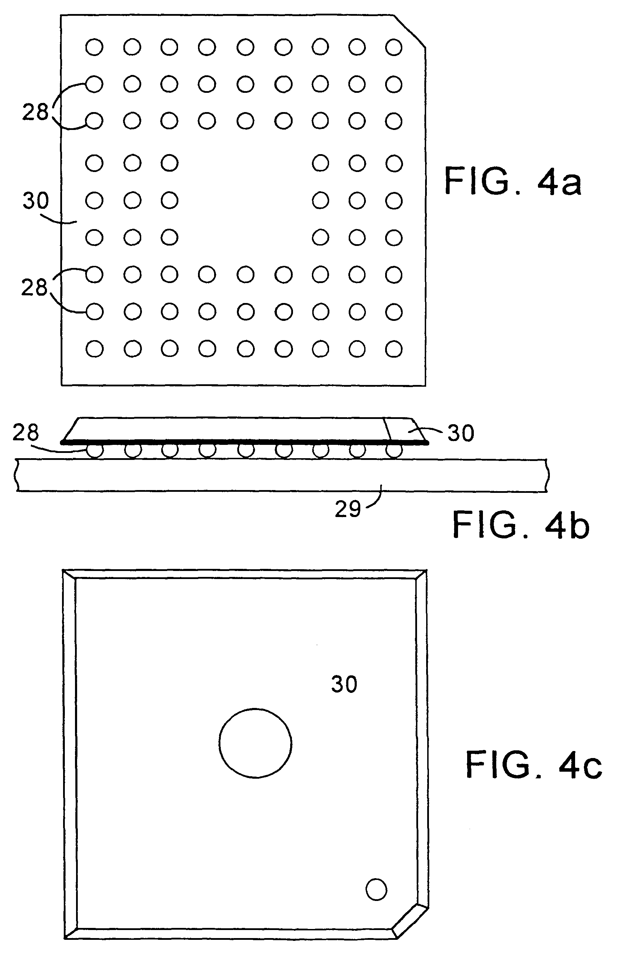

In der FIG. 2 ist ebenfalls schematisch ein integrierter elektrischer Halbleiter-Schaltungsbaustein (Chip) 25 mit zwei externe Test-Anschlußkontaktstellen bildenden Test-Kontaktpunkten (Test-Pads; Test-Balls) 26 und 27 dargestellt, über die Signale von im Einbau nicht zugänglichen anderen Kontaktpunkten (Pads; Balls) 28 eines BGA-Gehäuses beobachtet werden können. Wie FIG. 4a, 4b und 4c in drei verschiedenen Ansichten zeigen, sind die Kontaktpunkte 28 zum Systemboard 29 nicht zugänglich, da sich die Kontaktpunkte 28 auf der Unterseite des Gehäuses 30 befinden und damit zwischen dem Gehäuse 30 und dem Systemboard 29 verschwinden.

Somit sind die Signale an den Kontaktpunkten 28 für Test- und Analysezwecke nicht abgreifbar. Zur selektiven Durchschaltung der an den Kontaktpunkten 28 vorliegenden Signale ist entsprechend der FIG. 2 eine Multiplex-Schaltung 31 vorgesehen, deren Eingänge 32 mit den einzelnen Kontaktpunkten 28 verbunden sind.

Die Ausgänge 33 und 34 der Multiplex-Schaltung 31 sind mit den beiden externen Test-Kontaktpunkten (Test-Balls) 26 bzw. 27 elektrisch verbunden. Gesteuert wird die Durchschaltung der Multiplex-Schaltung 31, die z.B. als Logik oder Tristate realisiert werden kann, von einem Steuerregister 35, das über einen Controller, einen digitalen Signalprozessor oder einen Tapcontroller während des Betriebs programmierbar ist.

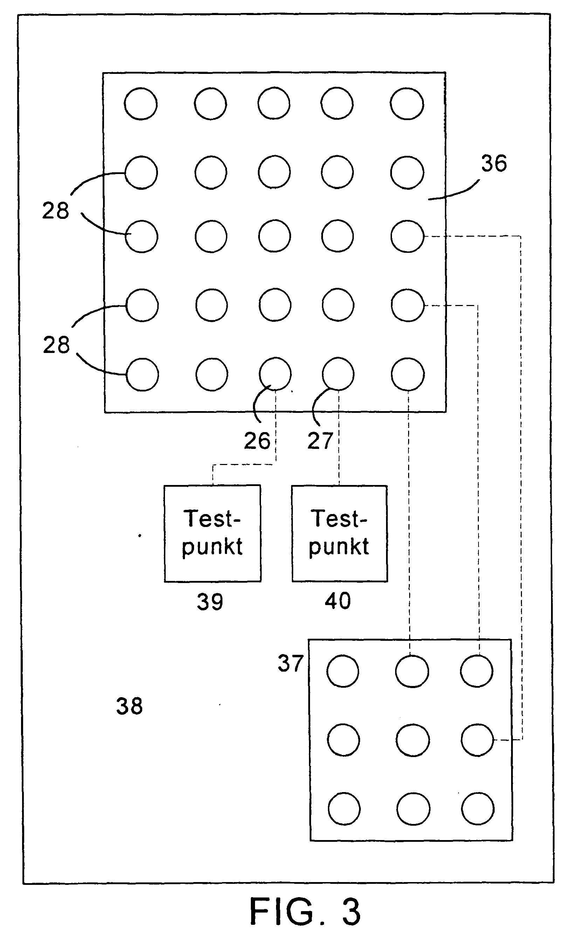

In der FIG. 3 ist eine schematische Ansicht von jeweils in einem BGA-Gehäuse montierten integrierten Halbleiter-Schaltungsbausteinen 36 und 37 in einem Gesamtsystem dargestellt, das auf einem kundenspezifischen Systemboard 38 aufgebaut ist. Auf dem Systemboard 38 sind zwei metallische Testpunkte 39 und 40 aufgebracht, die mit den beiden Test-Kontaktpunkten 26 und 27 elektrisch verbunden sind. Die Signale der beiden als Test-Kontaktpunkte 26 und 27 definierten Balls des integrierten Halbleiter-Schaltungsbausteins 36 werden auf dem Svstemboard 38 an den beiden Testpunkten 39 und 40 sichtbar gemacht.

Auf diese beiden Kontaktpunkte 26 und 27 und somit auf die Testpunkte 39 und 40 können die Signale von allen anderen Kontaktpunkten 28 des integrierten Schaltungsbausteins 36 sichtbar gemacht werden. Die gesteuerte selektive Durchschaltung der einzelnen Signale von allen Kontaktpunkten 28 zu den Test-Kontaktpunkten 26 bzw. 27 erfolgt entsprechend FIG. 1 mittels der Multiplex-Schaltung 31.

## Patentansprüche

1. Einrichtung zur elektrischen Vermessung und Analyse von an extern nicht zugänglichen Schaltungsstellen vorliegenden elektrischen Signalen eines integrierten, mit einer Vielzahl von Anschlußkontaktstellen (Pads; Pins; Balls) versehenen Schaltungsbausteins (IC; Integrated Circuit; Chip), wobei am integrierten Schaltungsbaustein (1) eine oder mehrere externe Test-Anschlußkontaktstellen (2, 3) vorgesehen sind, an die zu vermessende bzw. zu analysierende Signale (4, 5, 6) jeweils selektiv durchschaltbar über bausteininterne Leitungswege von den extern nicht zugänglichen Schaltungsstellen (15 bis 20) herangeführt sind,
**dadurch gekennzeichnet,**
**daß** an eine (2) der externen Test-Anschlußkontaktstellen (2, 3) selektiv durchschaltbar ein Referenzsignal über einen bausteininternen Leitungsweg von einer extern nicht zugänglichen Schaltungsstelle (15 bis 17) herangeführt ist und daß an die andere Test-Anschlußkontaktstelle (3) bzw. an die anderen Test-Anschlußkontaktstellen zu vermessende bzw. zu analysierende Signale jeweils selektiv durchschaltbar über bausteininterne Leitungswege von extern nicht zugänglichen Schaltungsstellen (18 bis 20) herangeführt sind.

2. Einrichtung nach Anspruch 1,
**dadurch gekennzeichnet,**
**daß** nur zwei externe Test-Anschlußkontaktstellen (2, 3) vorgesehen sind.

3. Einrichtung nach einem der vorhergehenden Ansprüche,
**dadurch gekennzeichnet,**
**daß** die nicht zugänglichen Signale (4, 5, 6) interne Chip-signale des integrierten Schaltungsbausteins (1) sind, der so ausgelegt ist, daß diese Signale einschließlich von Referenzsignalen selektiv durchschaltbar an die Test-Anschlußkontaktstellen (2, 3) geleitet sind.

4. Einrichtung nach einem der Ansprüche 1 oder 2,
**dadurch gekennzeichnet,**
**daß** die nicht zugänglichen Signale solche Signale sind, die an nicht zugänglichen Kontaktpunkten (28) des Gehäuses eines integrierten Schaltungsbausteins (25) vorliegen und daß diese Signale einschließlich von Referenzsignalen in selektiver Durchschaltung an die Test-Anschlußkontaktstellen (26, 27) geleitet sind, die durch besondere der Kontaktpunkte (28) gebildet sind.

5. Einrichtung nach Anspruch 4,
**dadurch gekennzeichnet,**
**daß** das Gehäuse des integrierten Schaltungsbausteins ein sogenanntes BGA-Gehäuse (Ball Grid Array-Gehäuse) ist, bei dem die durch Kontaktpunkte (Balls) realisierten Test-Anschlußkontaktstellen (28) nicht zugänglich sind, weil sich die Kontaktpunkte auf der Unterseite des BGA-Gehäuses (30) befinden und damit zwischen dem Gehäuse und einem Systemboard (29, 38), auf dem das Gehäuse angebracht ist, verschwinden und daß die besonderen Kontaktpunkte (26, 27), an welche die zu vermessenden und zu analysierenden Signale anderer Kontaktpunkte sowie die ebenfalls an anderen Kontaktpunkten vorliegenden Referenzsignale in selektiver Durchschaltung zugeleitet sind, mit entsprechend vielen metallischen Testpunkten (39, 40) auf dem Systemboard (29, 38) elektrisch leitend verbunden sind.

6. Einrichtung nach einem der vorhergehenden Ansprüche,
**dadurch gekennzeichnet,**
**daß** im integrierten Schaltungsbaustein (1; 25) zur selektiven Durchschaltung eine zeitlich gesteuerte Multiplex-Schaltung (7, 8; 31) vorgesehen ist, über welche die verschiedenen zu vermessenden und zu analysierenden Signale und gegebenenfalls die jeweiligen Referenzsignale an die externen Test-Anschlußkontaktstellen (2, 3; 26, 27) durchgeschaltet werden.

7. Einrichtung nach Anspruch 4 und 6,
**dadurch gekennzeichnet,**
**daß** die zeitlich gesteuerte Multiplex-Schaltung (31) in dem vom BGA-Gehäuse umschlossenen integrierten Schaltungsbaustein (25) vorgesehen ist und daß die nicht als externe Test-Anschlußkontaktstellen (28) dienenden Kontaktpunkte elektrisch leitend mit Eingängen (32) der Multiplex-Schaltung (31) verbunden sind, deren Ausgänge (33, 34) mit den besonderen, die externen Test-Anschlußkontaktstellen (26, 27) bildenden Kontaktpunkten des BGA-Gehäuses elektrisch leitend verbunden sind.

8. Einrichtung nach Anspruch 6 oder 7,
**dadurch gekennzeichnet,**
**daß** die die selektive Durchschaltung an die externen Test-Anschlußkontaktstellen (2, 3; 26, 27) vorgebende Steuerung der Multiplex-Schaltung (7, 8; 31) programmierbar ausgebildet ist.

9. Einrichtung nach einem der vorhergehenden Ansprüche,
**dadurch gekennzeichnet,**
**daß** die Test-Anschlußkontaktstellen (2, 3) wahlweise in umgekehrter Betriebsrichtung zur Eingabe von Signalen an die extern nicht zugänglichen Schaltungsstellen (15 bis 20) des integrierten Schaltungsbausteins (1) dienen (Eingabe-Mode).

10. Einrichtung nach einem der vorhergehenden Ansprüche,
**gekennzeichnet durch**
eine Verwendung zur Analyse des integrierten Schaltungsbausteins (1) mittels eines Bausteintesters, dem die an den Test-Anschlußkontaktstellen (2, 3) jeweils vorliegenden Signale zur Analyse eingegeben werden.

11. Einrichtung nach einem der Ansprüche 1 bis 9,
**gekennzeichnet durch**
eine Verwendung zur Analyse des integrierten Schaltungsbausteins (1) in einer Applikation innerhalb eines Systems, wobei die an den Test-Anschlußkontaktstellen (2, 3) vorliegenden Signale vermessen und analysiert werden.

12. Einrichtung nach Anspruch 11,
**gekennzeichnet durch**
eine zusätzliche Verwendung zur Analyse des Systems, in welchem der integrierte Schaltungsbaustein (1) eingesetzt ist.

## Claims

1. Device for electrical measurement and analysis of electrical signals which are present at circuit points that are not externally accessible in an integrated circuit component (IC; integrated circuit; chip) which is provided with a large number of connecting contact points (pads; pins; balls),
with the integrated circuit component (1) is provided with one or more external test connecting contact points (2, 3) to which signals (4, 5, 6) which are to be measured or are to be analysed are in each case selectively applied such that they can be passed on via routes within the component from the circuit points (15 to 20) which are not externally accessible,
**characterized in that** a reference signal is selectively applied such that it can be passed on via a route within the component to one (2) of the external test connecting contact points (2, 3) from a circuit point (15 to 17) which is not externally accessible, and **in that** signals which are to be measured or are to be analysed can in each case be selectively applied such that they can be passed on via routes within the component to the other test connecting contact points (3) from circuit points (18 to 20) which are not externally accessible.

2. Device according to Claim 1,
**characterized in that** only two external test connecting contact points (2, 3) are provided.

3. Device according to one of the preceding claims,
**characterized in that** the signals (4, 5, 6) which are not accessible are internal chip signals in the integrated circuit component (1), which is designed such that the signals, including reference signals, can be selectively passed on to the test connecting contact points (2, 3).

4. Device according to one of Claims 1 and 2,
**characterized in that** the inaccessible signals are signals which are present at inaccessible contact points (28) on the package of an integrated circuit component (25), and **in that** the signals, including reference signals, are selectively passed on to the test connecting contact points (26, 27) which are formed by particular ones of the contact points (28).

5. Device according to Claim 4,
**characterized in that** the package of the integrated circuit component is a so-called BGA package (ball grid array package), in which the test connecting contact points (28), which are provided by contact points (balls) are inaccessible since the contact points are located on the lower face of the BGA package (30) and are thus concealed between the package and a system board (29, 38) on which the package is fitted, and **in that** the particular contact points (26, 27) to which those signals which are to be measured and are to be analysed from other contact points are supplied and to which those reference signals which are likewise present at other contact points are supplied such that they are passed on selectively, are electrically conductively connected to a corresponding number of metallic test points (39, 40) on the system board (29, 38) .

6. Device according to one of the preceding claims,
**characterized in that** a time-controlled multiplexing circuit (7, 8; 31) is provided for passing on signals selectively in the integrated circuit component (1; 25), via which multiplexing circuit (7, 8; 31) the various signals which are to be measured and are to be analysed and, if appropriate, the respective reference signals, are passed on to the external test connecting contact points (2, 3; 26, 27).

7. Device according to Claims 4 and 6,
**characterized in that** the time-controlled multiplexing circuit (31) is provided in the integrated circuit component (25) which is surrounded by the BGA package, and **in that** those contact points which are not used as external test connecting contact points (28) are electrically conductively connected to inputs (32) of the multiplexing circuit (31), whose outputs (33, 34) are electrically conductively connected to those particular contact points in the BGA package which form the external test connecting contact points (26, 27).

8. Device according to Claim 6 or 7,
**characterized in that** the control of the multiplexing circuit (7, 8; 31), which predetermines the selective passing on of signals to the external test connecting contact points (2, 3; 26, 27) is programmable.

9. Device according to one of the preceding claims,
**characterized in that** the test connecting contact points (2, 3) are selectively used in the opposite operating direction for inputting signals to those circuit points (15 to 20) which are not externally accessible in the integrated circuit component (1) (input mode).

10. Device according to one of the preceding claims,
**characterized by** use for analysis of the integrated circuit component (1) by means of a component tester, to which those signals which are respectively present at the test connecting contact points (2, 3) are applied for analysis.

11. Device according to one of Claims 1 to 9,
**characterized by** use for analysis of the integrated circuit component (1) in an application within a system, in which the signals which are present at the test connecting contact points (2, 3) are measured and analysed.

12. Device according to Claim 11,
**characterized by** additional use for analysis of the system in which the integrated circuit component (1) is used.

## Revendications

1. Dispositif de mesure et d'analyse électrique de signaux électriques, présents à des emplacements de circuit non accessibles de l'extérieur, d'un circuit intégré (IC ; circuit intégré ; puce) pourvu d'une pluralité de contacts de connexion (pastilles ; broches ; billes), moyennant quoi un ou plusieurs contacts de connexion de test externes (2,3) sont prévus sur le circuit intégré (1), sur lesquels les signaux à mesurer, respectivement à analyser (4,5,6) sont respectivement appliqués en interconnexion sélective par l'intermédiaire de pistes conductrices internes au circuit partant des emplacements de circuit non accessibles de l'extérieur (15 à 20),
**caractérisé en ce que**
sur un (2) des contacts de connexion de test externes (2,3), un signal de référence est appliqué en interconnexion sélective par l'intermédiaire d'une piste conductrice interne au circuit partant d'un emplacement de circuit (15 à 17) non accessible de l'extérieur et **en ce que** sur l'autre contact de connexion de test (3), respectivement sur les autres contacts de connexion de test, des signaux à mesurer, respectivement à analyser sont respectivement appliqués en interconnexion sélective par l'intermédiaire de pistes conductrices internes au circuit partant des emplacements de circuit non accessibles de l'extérieur (18 à 20).

2. Dispositif selon la revendication 1,
**caractérisé en ce que**
seuls deux contacts de connexion de test externes (2,3) sont présents.

3. Dispositif selon l'une des revendications précédentes,
**caractérisé en ce que**
les signaux non accessibles (4,5,6) sont des signaux internes de puce du circuit intégré (1), lequel est conçu de telle sorte que ces signaux, y compris les signaux de référence, soient guidés en interconnexion sélective vers les contacts de connexion de test (2,3).

4. Dispositif selon l'une des revendications 1 ou 2,
**caractérisé en ce que**
les signaux non accessibles sont des signaux, qui sont présents aux points de contact non accessibles (28) du boîtier d'un circuit intégré (25) et **en ce que** ces signaux, y compris les signaux de référence, sont guidés en interconnexion sélective vers les contacts de connexion de test (26,27), qui sont formés par des points de contact particuliers (28).

5. Dispositif selon la revendication 4,
**caractérisé en ce que**
le boîtier du circuit intégré est un boîtier BGA (Ball Grid Array), dans lequel les contacts de connexion de test (28) réalisés par les points de contact (billes) ne sont pas accessibles, parce que les points de contact se trouvent sur le côté inférieur du boîtier BGA (30) et donc disparaissent entre le boîtier et une carte mère (29,38), sur laquelle le boîtier est monté, et **en ce que** les points de contact particuliers (26,27), sur lesquels les signaux à mesurer, respectivement à analyser d'autres points de contact ainsi que les signaux de référence également présents à d'autres points de contact sont guidés en interconnexion sélective et reliés de manière conductrice d'électricité avec un nombre correspondant de points de test métalliques (39,40) sur la carte mère (29,38).

6. Dispositif selon une des revendications précédentes,
**caractérisé en ce que**
dans le circuit intégré (1 ; 25), un circuit de multiplexage à commande temporelle (7,8 ; 31) est prévu pour l'interconnexion sélective, par l'intermédiaire duquel les différents signaux à mesurer et à analyser et le cas échéant les signaux de référence respectifs sont interconnectés avec les contacts de connexion de test externes (2,3 ; 26,27).

7. Dispositif selon les revendications 4 et 6,
**caractérisé en ce que**
le circuit de multiplexage à commande temporelle (31) est prévu dans le circuit intégré (25) inclus dans le boîtier BGA et **en ce que** les points de contact ne servant pas de contacts de connexion de test externes (28) sont reliés de manière conductrice d'électricité aux entrées (32) du circuit de multiplexage (31), dont les sorties (33,34) sont reliées d'une manière conductrice d'électricité aux points de contact particuliers du boîtier BGA, formant les contacts de connexion de test externes (26,27).

8. Dispositif selon la revendication 6 ou 7,
**caractérisé en ce que**
l'unité de commande du circuit de multiplexage (7,8 ; 31) établissant l'interconnexion sélective sur les contacts de connexion de test externes (2,3 ; 26,27) est réalisée de manière programmable.

9. Dispositif selon l'une quelconque des revendications précédentes,
**caractérisé en ce que**
les contacts de connexion de test (2,3) servent alternativement, en mode de fonctionnement inverse, à entrer des signaux dans les emplacements de circuit non accessibles de l'extérieur (15 à 20) du circuit intégré (1) (mode d'entrée).

10. Dispositif selon l'une quelconque des revendications précédentes,
**caractérisé par**
une utilisation pour analyser le circuit intégré (1) au moyen d'un testeur de circuit, dans lequel sont entrés dans un but d'analyse les signaux respectivement présents aux contacts de connexion de test (2,3).

11. Dispositif selon l'une quelconque des revendications 1 à 9,
**caractérisé par**
une utilisation pour analyser le circuit intégré (1) dans une application à l'intérieur d'un système, moyennant quoi les signaux présents aux contacts de connexion de test (2,3) sont mesurés et analysés.

12. Dispositif selon la revendication 11,
**caractérisé par**
une utilisation supplémentaire pour l'analyse du système, dans lequel le circuit intégré (1) est employé.
